(19)

Europäisches
Patentamt
European
Patent Office
Office européen
des brevets

(11)  EP 4 614 174 A1

(12)  **EUROPEAN PATENT APPLICATION**
published in accordance with Art. 153(4) EPC

(43) Date of publication:
10.09.2025  Bulletin 2025/37

(21) Application number: 23902389.8

(22) Date of filing: 14.11.2023

(51) International Patent Classification (IPC):
*G01R 31/52* (2020.01)    *G01R 31/385* (2019.01)

(52) Cooperative Patent Classification (CPC):
**G01R 31/385; G01R 31/52;** Y02E 60/10

(86) International application number:
**PCT/CN2023/131622**

(87) International publication number:
**WO 2024/125189 (20.06.2024 Gazette 2024/25)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 12.12.2022  CN 202211611439

(71) Applicant: ZTE CORPORATION
Shenzhen, Guangdong 518057 (CN)

(72) Inventors:
• WEN, Tao
  Shenzhen, Guangdong 518057 (CN)

• KONG, Peng
  Shenzhen, Guangdong 518057 (CN)
• HOU, Chunhua
  Shenzhen, Guangdong 518057 (CN)
• LIU, Ming
  Shenzhen, Guangdong 518057 (CN)
• LIU, Guoguang
  Shenzhen, Guangdong 518057 (CN)

(74) Representative: **Chimini, Francesco et al**
**Jacobacci & Partners S.p.A.**
**Piazza della Vittoria 11**
**25122 Brescia (IT)**

(54)  **SHORT CIRCUIT EARLY-WARNING METHOD AND DEVICE FOR ENERGY STORAGE
BATTERY**

(57)    Embodiments of the present disclosure provide a short circuit early-warning method and apparatus for an energy storage battery. The method includes: clustering analysis is performed on a U-Absolute Change (UAC) of a battery cell, and a U-Baseline Change (UBC) of the battery cell is calculated according to the UAC of each clustering center; a training set is constructed according to the UBC, and the training set is partitioned into a plurality of training subsets using a locality-sensitive hashing table; an early-warning neural network model is respectively trained according to the plurality of training subsets, and an early-warning threshold of each training subset is respectively calculated; and short circuit early-warning is performed on a battery cell according to the early-warning neural network model and the early-warning threshold and in conjunction with battery cell state data at the current moment.

Clustering analysis is performed on a U-Absolute Change (UAC) of a battery cell, and a U-Baseline Change (UBC) of the battery cell is calculated according to the UAC of each clustering center — S202

A training set is constructed according to the UBC, and the training set is partitioned into a plurality of training subsets using a locality-sensitive hashing table — S204

An early-warning neural network model is respectively trained according to the plurality of training subsets, and an early-warning threshold of each training subset is respectively calculated — S206

Short circuit early-warning is performed on a battery cell according to the early-warning neural network model and the early-warning threshold and in conjunction with battery cell state data at the current moment — S208

Fig.2

EP 4 614 174 A1

**Description**

**Cross-Reference to Related Application**

The present disclosure claims the priority of Chinese Patent Application CN202211611439.9, filed on 12 December 2022 and entitled " Short Circuit Early-Warning Method and Apparatus for Energy Storage Battery", the disclosure of which is incorporated herein by reference in its entirety.

**Technical Field**

Embodiments of the present disclosure relate to the field of safety control and management of energy storage batteries, and in particular, to a short circuit early-warning method and apparatus for an energy storage battery.

**Background**

The safety of energy storage batteries is a critical constraint in the development of new energy, and the industry has long been highly focused on it. An internal short circuit is a significant accompanying phenomenon during the thermal runaway process of energy storage batteries, where the separator or diaphragm between the positive and negative electrodes of the battery ruptures, leading to direct contact between the positive and negative electrodes and causing a short circuit. If internal short circuits in energy storage batteries can be identified and warned of early, it can provide valuable time for implementing subsequent safety strategies, effectively enhancing the safety of the energy storage system.

In the current energy storage scenario, battery cells need to undergo pre-screening to select battery cells with similar internal characteristics to form battery packs; and these battery packs are then managed and scheduled as a unit for unified load management and dispatch. Therefore, battery cells within the same battery pack have the same workload, similar state of charge (SOC), and similar internal electrochemical characteristics. After an internal short circuit occurs in an energy storage battery, the short circuited battery cell undergoes self-discharge, resulting in a voltage difference between the short circuited battery cell and normal battery cells in the battery pack. This phenomenon can reveal internal short circuit faults, enable early warning, and provide valuable time for implementing energy storage safety strategies.

Existing voltage-difference-based early-warning policies for battery internal short circuits still face severe limitations. On one hand, inherent differences between battery cells in the same group and random errors in voltage sensors lead to significant voltage difference fluctuations, severely interfering with strategies that compare voltage readings or absolute change rates across battery cells; and on the other hand, due to the electrochemical characteristics of the battery itself, the magnitude of voltage changes or fluctuations in the battery cell per unit time varies under different SOC levels and current loads. The above problem makes it difficult to uniformly set the voltage difference threshold between normal and internally short circuited battery cells based on experience.

Data-driven internal short circuit early-warning methods based on the assumption of battery pack consistency can avoid additional sensor costs and are highly promising. However, further optimization is needed regarding load conditions, battery cell states, and inherent battery cell differences, so as to achieve a balance between cost and accuracy.

**Summary**

According to one embodiment of the present disclosure, provided is a short circuit early-warning method for an energy storage battery, including: clustering analysis is performed on a U-Absolute Change (UAC) of a battery cell, and a U-Baseline Change (UBC) of the battery cell is calculated according to the UAC of each clustering center; a training set is constructed according to the UBC, and the training set is partitioned into a plurality of training subsets using a locality-sensitive hashing table; an early-warning neural network model is respectively trained according to the plurality of training subsets, and an early-warning threshold of each training subset is respectively calculated; and short circuit early-warning is performed on a battery cell according to the early-warning neural network model and the early-warning threshold and in conjunction with battery cell state data at the current moment.

According to another embodiment of the present disclosure, provided is a short circuit early-warning apparatus for an energy storage battery, including: a clustering analysis module, configured to perform clustering analysis on a U-Absolute Change (UAC) of a battery cell, and calculating a U-Baseline Change (UBC) of the battery cell according to the UAC of each clustering center; a set construction module, configured to construct a training set according to the UBC, and partition the training set into a plurality of training subsets using a locality-sensitive hashing table; a network training module, configured to respectively train an early-warning neural network model according to the plurality of training subsets, and respectively calculate an early-warning threshold of each training subset; and a state early-warning module, configured to perform short circuit early-warning on a battery cell according to the early-warning neural network model and the early-warning threshold and in conjunction with battery cell state data at the current moment.

According to yet another embodiment of the present disclosure, further provided is a computer readable storage medium, wherein a computer program is stored in the computer readable storage medium, and the computer program is configured to cause, when executed, the processor to perform the steps in any one of the described method embodiments.

According to yet another embodiment of the present disclosure, further provided is an electronic device, including a memory and a processor; the memory stores a computer program, wherein the processor is configured to execute the computer program to perform steps in any one of the described method embodiments.

## Brief Description of the Drawings

Fig. 1 is a hardware structure block diagram of a computer terminal of a short circuit early-warning method for an energy storage battery according to an embodiment of the present disclosure;

Fig. 2 is a flowchart of a short circuit early-warning method for an energy storage battery according to an embodiment of the present disclosure;

Fig. 3 is a flowchart of a short circuit early-warning method for an energy storage battery according to an embodiment of the present disclosure;

Fig. 4 is a flowchart of training set partitioning according to embodiments of the present disclosure;

Fig. 5 is a flowchart of short circuit early-warning for the current battery cell according to an embodiment of the present disclosure;

Fig. 6 is a structural block diagram of a short circuit early-warning apparatus for an energy storage battery according to an embodiment of the present disclosure;

Fig. 7 is a structural block diagram of a short circuit early-warning apparatus for an energy storage battery according to an embodiment of the present disclosure;

Fig. 8 is a block diagram of a set construction module according to an embodiment of the present disclosure;

Fig. 9 is a structural block diagram of a state early-warning module according to an embodiment of the present disclosure;

Fig. 10 is a flowchart of a short circuit early-warning method for an energy storage battery according to a scenario embodiment of the present disclosure.

## Detailed Description of the Embodiments

The embodiments of the present disclosure are described in detail with reference to the accompanying drawings and in conjunction with the embodiments.

It should be noted that the terms "first", "second" etc. in the description, claims, and accompanying drawings of the embodiments of the present disclosure are used to distinguish similar objects, and are not necessarily used to describe a specific sequence or order.

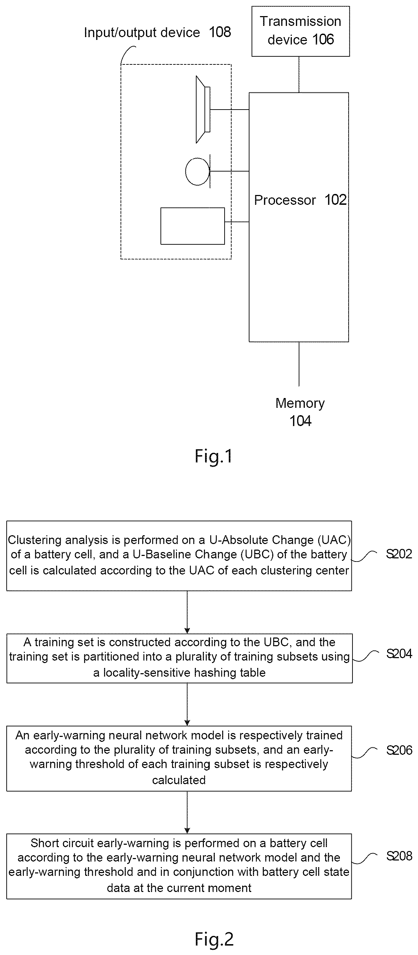

The method embodiment provided in the embodiment I of the present application may be executed in a mobile terminal, a computer terminal, or a similar computing device. Taking operation on a mobile terminal as an example, Fig. 1 is a hardware structure block diagram of a computer terminal of a short circuit early-warning method for an energy storage battery according to an embodiment of the present disclosure. As shown in Fig. 1, the computer terminal may include one or more (only one is shown in Fig. 1) processors 102 (the processors 102 may include, but are not limited to, a microprocessor MCU or a processing device such as a programmable logic device FPGA) and a memory 104 configured to store data, wherein the computer terminal can further include a transmission device 106 for a communication function and an input/output device 108. The structure shown in Fig. 1 is for illustrative purposes only, but not limit the structure of the computer terminal. For example, the computer terminal may also include more or fewer components than those shown in Fig. 1, or have different configurations from that shown in Fig. 1.

The memory 104 may be configured to store a computer program, for example, a software program and a module of application software, such as a computer program corresponding to the short circuit early-warning method for an energy storage battery in the embodiment of the present disclosure. The processor 102 runs the computer program stored in the memory 104, so as to execute various function applications and data processing, that is, to implement the foregoing method. The memory 104 may include a high-speed random access memory, and may also include a non-transitory memory, such as one or more magnetic storage apparatuses, flash memories, or other non-transitory solid-state memories. In some instances, the memory 104 may further include a memory remotely located from the processor 102, and the remote memory may be connected to the computer terminal by a network. Examples of the network above includes, but is not limited to, an Internet, intranets, a local area network, a mobile communication network, and combinations thereof.

The transmission device 106 is configured to receive or transmit data over a network. The described network may include a wireless network provided by a communication provider of the mobile terminal. In one example, the transmission device 106 includes a network interface controller (NIC) which may be connected to other network devices by means of a base station, thereby being able to communicate with the Internet. In an example, the transmission device 106 can be a radio frequency (RF) module for communicating wirelessly with the Internet.

Provided in the embodiments of the present disclosure is a short circuit early-warning method for an energy storage battery, which operates on the described computer terminal. Fig. 2 is a flowchart of a short circuit early-warning method for an energy storage battery according to an embodiment of the present disclosure. As shown in Fig. 2, the flow includes the following steps:

step S202: clustering analysis is performed on a U-Absolute Change (UAC) of a battery cell, and a U-Baseline Change (UBC) of the battery cell is calculated according to the UAC of each clustering center.

In the embodiments of the present disclosure, the UAC is defined as: the U-Absolute Change of the ith battery cell at a moment t; $UAC(t, i) = U(t, i)-U(t-1, i)/T$, where $U(t, i)$ is a real-time voltage value of the ith battery cell at the moment t, and T is a time interval between the moment t-1 and the moment t.

Step S204: a training set is constructed according to the UBC, and the training set is partitioned into a plurality of training subsets using a locality-sensitive hashing table;

step S206: an early-warning neural network model is respectively trained according to the plurality of training subsets, and an early-warning threshold of each training subset is respectively calculated; and

step S208: short circuit early-warning is performed on a battery cell according to the early-warning neural network model and the early-warning threshold and in conjunction with battery cell state data at the current moment.

According to the described steps, by performing clustering analysis on a U-Absolute Change (UAC) of a battery cell, and calculating a U-Baseline Change (UBC) of the battery cell according to the UAC of each clustering center; constructing a training set according to the UBC, and partitioning the training set into a plurality of training subsets using a locality-sensitive hashing table; respectively training an early-warning neural network model according to the plurality of training subsets, and respectively calculating an early-warning threshold of each training subset; and performing short circuit early-warning on a battery cell according to the early-warning neural network model and the early-warning threshold and in conjunction with battery cell state data at the current moment, the present disclosure solves the problem of inaccurate short circuit early-warning of energy storage batteries in some cases due to the original differences between battery cells in the energy storage battery pack and random errors of voltage sensors, thereby achieving the effect of reasonably and accurately giving short circuit early-warnings for energy storage batteries on the basis of the state of charge of the battery cells.

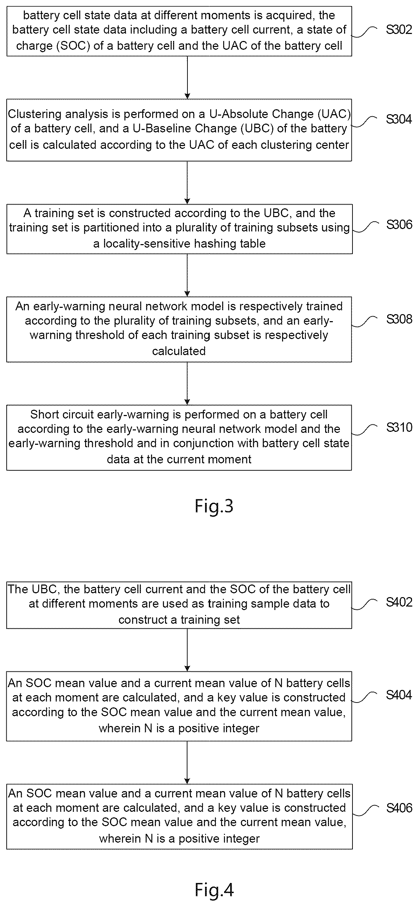

In an exemplary embodiment, before performing clustering analysis on the UAC of the battery cell, and calculating the UBC of the battery cell according to the UAC of each clustering center, the method further includes: battery cell state data at different moments is acquired, the battery cell state data including a battery cell current, a state of charge (SOC) of a battery cell and the UAC of the battery cell. Fig. 3 is a flowchart of a short circuit early-warning method for an energy storage battery according to an embodiment of the present disclosure. As shown in Fig. 3, the flow includes the following steps:

step S302: battery cell state data at different moments is acquired, the battery cell state data including a battery cell current, a state of charge (SOC) of a battery cell and the UAC of the battery cell;

step S304: clustering analysis is performed on a U-Absolute Change (UAC) of a battery cell, and a U-Baseline Change (UBC) of the battery cell is calculated according to the UAC of each clustering center;

step S306: a training set is constructed according to the UBC, and the training set is partitioned into a plurality of training subsets using a locality-sensitive hashing table;

step S308: an early-warning neural network model is respectively trained according to the plurality of training subsets, and an early-warning threshold of each training subset is respectively calculated; and

step S310: short circuit early-warning is performed on a battery cell according to the early-warning neural network model and the early-warning threshold and in conjunction with battery cell state data at the current moment.

In an exemplary embodiment, performing clustering analysis on the UAC of the battery cell, and calculating the UBC of the battery cell according to the UAC of each clustering center include: K-Medians clustering are performed on the UAC of the battery cell at each moment, a clustering result with the best clustering effect is selected, and the UAC of each clustering center is acquired; and calculating the UBC of the battery cell according to the UAC of each clustering center,

$$UBC(t,i) = UAC(t,i) * \sum_{d=1}^{Q(t)} \frac{1}{\max(|UCenter(t,d)|, 0.001)} / Q(t)$$

wherein *t* represents a moment, *i* represents an ith battery cell, *UBC(t,i)* represents the UAC of the ith battery cell at the moment *t*, *UAC(t,i)* represents the UBC of the ith battery cell at the moment *t*, *UCenter(t,d)* represents the UAC of a dth clustering center at the moment t, *Q(t)* represents an optimal number of clusters at the moment t, and $d \in [1,Q(t)]$, both i and d being integers.

In an exemplary embodiment, Fig. 4 is a flowchart of training set partitioning according to embodiments of the present disclosure. As shown in Fig. 4, constructing the training set according to the UBC, and partitioning the training set into a plurality of training subsets using the locality-sensitive hashing table include:

step S402: the UBC, the battery cell current and the SOC of the battery cell at different moments are used as training sample data to construct a training set;

step S404: an SOC mean value and a current mean value of N battery cells at each moment are calculated, and a key value is constructed according to the SOC mean value and the current mean value, wherein N is a positive integer; and

step S406: the training sample data at different moments is inserted into the locality-sensitive hashing table according to the key value, and the training sample data in each bucket in the locality-sensitive hashing table is used as a training subset.

In one exemplary embodiment, respectively training the early-warning neural network model according to the plurality of training subsets, and respectively calculating the early-warning threshold of each training subset include: a corresponding single-hidden-layer neural network for each training subset is constructed, the training subset is taken as an independent variable matrix and a dependent variable matrix of the single-hidden-layer neural network; and a gradient descent algorithm is used for training, wherein the number of input-layer nodes of the single-hidden-layer neural network is 3*N, the number of output-layer nodes is 3*N, and the number of hidden-layer nodes is 1.5*N.

In an exemplary embodiment, respectively calculating the early-warning threshold of each training subset includes: for each training subset, input vectors of the training subset are input into the single-hidden-layer neural network one by one, to obtain a plurality of corresponding output vectors, wherein the input vectors are composed of a battery cell current, an SOC and a UBC; and calculating a vector element difference between an output vector at each moment and an input vector in the training subset, and the maximum value of the vector element difference of the current training subset is used as an early-warning threshold of the current training subset.

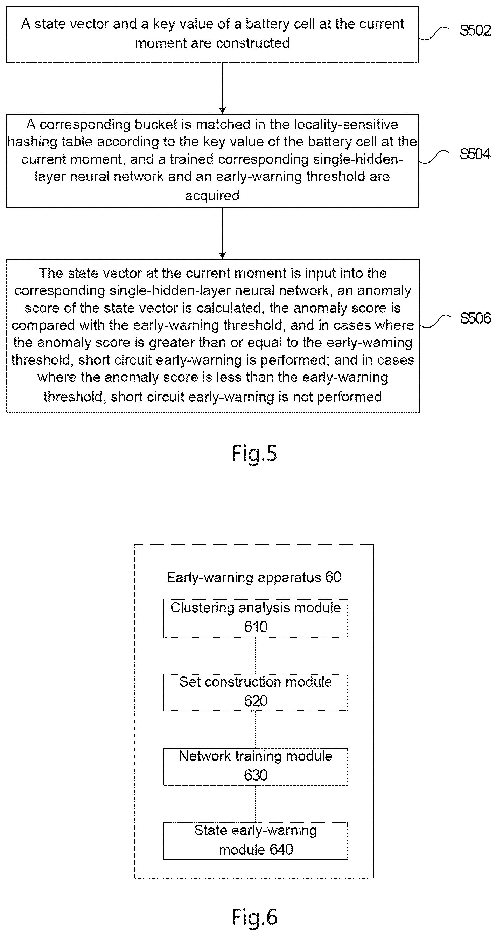

In an exemplary embodiment, Fig. 5 is a flowchart of short circuit early-warning for the current battery cell according to an embodiment of the present disclosure. As shown in Fig. 5, performing short circuit early-warning on a battery cell according to the early-warning neural network model and the early-warning threshold and in conjunction with battery cell state data at the current moment includes:

step S502: a state vector and a key value of a battery cell at the current moment are constructed;

step S504: a corresponding bucket is matched in the locality-sensitive hashing table according to the key value of the battery cell at the current moment, and a trained corresponding single-hidden-layer neural network and an early-warning threshold are acquired;

step S506: the state vector at the current moment is input into the corresponding single-hidden-layer neural network, an anomaly score of the state vector is calculated, the anomaly score is compared with the early-warning threshold, and in cases where the anomaly score is greater than or equal to the early-warning threshold, short circuit early-warning is performed; and in cases where the anomaly score is less than the early-warning threshold, short circuit early-warning is not performed.

In an exemplary embodiment, constructing the state vector and the key value of the battery cell at the current moment includes: the UBC of the battery cell at the current moment is calculated, and the state vector of the battery cell according to the battery cell current SOC and UBC of the battery cell are constructed; and an SOC mean value and a current mean value of the battery cell at the current moment are calculated, and the key value of the battery cell at the current moment is constructed according to the SOC mean value and the battery cell current mean value at the current moment.

In an exemplary embodiment, inputting the state vector at the current moment into the corresponding single-hidden-layer neural network, and calculating the anomaly score of the state vector include: the state vector at the current moment is input into the corresponding single-hidden-layer neural network to obtain an output vector; a maximum value of a vector element difference between the state vector and the output vector is calculated; and the maximum value of the vector element difference is taken as an anomaly score of the state vector.

The method in the described embodiments may be implemented by using software and necessary general hardware platforms, and of course may also be implemented using hardware, but in many cases, the former is a better embodiment. Based on such understanding, the essence of technical solution of the embodiments of the present disclosure, or in other words, the part of the technical solutions making contributions to the prior art, may be embodied in the form of a software product stored in a storage medium (such as a Read-Only Memory (ROM)/Random Access Memory (RAM), a magnetic disk and an optical disc), including a number of instructions for enabling a terminal device (which may be a mobile phone, a computer, a server, or a network device, etc.) to perform the methods described in various embodiments of the present disclosure.

The present embodiment further provides a short circuit early-warning apparatus for an energy storage battery, the apparatus is used for implementing the embodiments and implementations above, and what has been described will not be described repeatedly here. As used below, the term "module" may implement a combination of software and/or hardware of predetermined functions. Although the apparatus described in the following embodiments is preferably implemented in software, implementation in hardware or a combination of software and hardware is also possible and conceived.

Fig. 6 is a structural block diagram of a short circuit early-warning apparatus for an energy storage battery according to an embodiment of the present disclosure. As shown in Fig. 6, the early-warning apparatus 60 includes: a clustering analysis module 610, configured to perform clustering analysis on a U-Absolute Change (UAC) of a battery cell, and calculating a U-Baseline Change (UBC) of the battery cell according to the UAC of each clustering center; a set construction module 620, configured to construct a training set according to the UBC, and partition the training set into a plurality of training subsets using a locality-sensitive hashing table; a network training module 630, configured to respectively train an early-warning neural network model according to the plurality of training subsets, and respectively calculate an early-warning threshold of each training subset; and a state early-warning module 640, configured to perform short circuit early-warning on a battery cell according to the early-warning neural network model and the early-warning threshold and in conjunction with battery cell state data at the current moment.

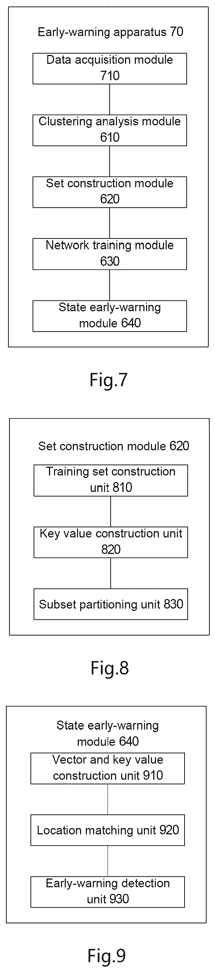

In an exemplary embodiment, Fig. 7 is a structural block diagram of a short circuit early-warning apparatus for an energy storage battery according to an embodiment of the present disclosure. As shown in Fig. 7, in addition to all modules shown in Fig. 6, the early-warning apparatus 70 further includes: a data acquisition module 710, configured to acquire battery cell state data at different moments, the battery cell state data including a battery cell current, a state of charge (SOC) of a battery cell and the UAC of the battery cell.

In an exemplary embodiment, Fig. 8 is a block diagram of a set construction module according to an embodiment of the present disclosure. As shown in Fig. 8, the set construction module 620 includes: a training set construction unit 810, configured to use the UBC, the battery cell current and the SOC of the battery cell at different moments as training sample data to construct a training set; a key value construction unit 820, configured to calculate an SOC mean value and a current mean value of N battery cells at each moment, and constructing a key value according to the SOC mean value and the current mean value, wherein N is a positive integer; and a subset partitioning unit 830, configured to insert the training sample data at different moments into the locality-sensitive hashing table according to the key value, and use the training sample data in each bucket in the locality-sensitive hashing table as a training subset.

In an exemplary embodiment, Fig. 9 is a structural block diagram of a state early-warning module according to an embodiment of the present disclosure. As shown in Fig. 9, the state early-warning module 640 includes: a vector and key value construction unit 910, configured to construct a state vector and a key value of a battery cell at the current moment; a location matching unit 920, configured to match a corresponding bucket in the locality-sensitive hashing table according to the key value of the battery cell at the current moment, and acquire a trained corresponding single-hidden-layer neural network and an early-warning threshold; an early-warning detection unit 930, configured to input the state vector at the current moment into the corresponding single-hidden-layer neural network, calculate an anomaly score of the state vector, compare the anomaly score with the early-warning threshold, and in cases where the anomaly score is greater than or equal to the early-warning threshold, perform short circuit early-warning; and in cases where the anomaly score is less than the early-warning threshold, not perform short circuit early-warning.

It should be noted that the modules above may be implemented by software or hardware, and the latter may be implemented in the following manner, but is not limited thereto. All the modules above are located in the same processor; or all the modules above are located in different processors in any arbitrary combination manner.

The embodiments of the present disclosure further provide a computer readable storage medium, wherein a computer program is stored in the computer readable storage medium, and the computer program is configured to cause, when executed, the processor to perform the steps in any one of the described method embodiments.

In an exemplary embodiment, the computer readable storage medium may include, but is not limited to, any medium that can store a computer program, such as a USB flash drive, a Read-Only Memory (ROM), a Random Access Memory (RAM), a removable hard disk, a magnetic disk, or an optical disc.

The embodiments of the present disclosure further provide an electronic apparatus, including a memory and a processor; the memory stores a computer program, wherein the processor is configured to execute the computer program to perform steps in any one of the method embodiments.

In an exemplary embodiment, the electronic device can further include a transmission device and an input/output device, wherein the transmission device is connected to the processor, and the input/output device is connected to the processor.

The modules or steps in the embodiments of the present disclosure can be implemented by using a general computing device, and they can be integrated in a single computing device, and can also be distributed over a network consisting of a plurality of computing devices. They may be implemented by using executable program codes of the computing devices. Thus, they can be stored in a storage device and executed by the computing devices. Furthermore, in some cases, the shown or described steps may be executed in an order different from that described here, or they can be respectively implemented by individual Integrated Circuit modules, or they can be implemented by making a plurality of the modules or steps into a single Integrated Circuit module. Thus, the embodiments of the present disclosure are not limited to any specific hardware and software combinations.

Scenario Embodiment 1

For solving the problem that inherent differences between battery cells in the same group and random errors in voltage sensors lead to significant voltage difference fluctuations, severely interfering with strategies that compare voltage readings or absolute change rates across battery cells, and the problem that due to the electrochemical characteristics of the battery itself, the magnitude of voltage changes or fluctuations in the battery cell per unit time varies under different SOC levels and current loads, in the present scenario embodiment, the following strategy is taken in the training stage of the neural network warning model:

(1) voltage difference fluctuations are suppressed using a clustering algorithm, to obtain a stable UBC to perform training.
By clustering the UAC of various battery cells in the energy storage battery pack within the same time period, calculating the harmonic mean of the representative center points of each cluster as the voltage change baseline at that time, and calculating the UBC of the battery cells, the negative impact of inherent differences between battery cells and voltage reading errors can be effectively reduced, thereby obtaining a robust training set (TrainSet).

(2) On the basis of combinations of different SOC and current loads, normal samples are partitioned into training subsets, models are trained respectively, and a threshold is calculated, that is, the fluctuation distribution laws of normal samples in different regions are learned to obtain a series of warning thresholds, rather than uniformly configuring the thresholds based on experiences.

The training set TrainSet is partitioned into mutually disjoint data region subsets, i.e., training subsets Train-Set(si), on the basis of different SOC and current loads; the early-warning neural network model ANN(si) is trained respectively on various subsets; and the corresponding early-warning thresholds θ(si) are calculated for the region subsets; that is, the early-warning thresholds are obtained in a data-driven manner, without relying on expert experience.

The partitioning of the data region subset TrainSet(si) is focused on: assembling the mean value of the SOC of each row of samples train_row(t) and the mean value of the current load I into a key value key(t); inserting Key(t) is into the locality-sensitive hashing table, and using the characteristics of locality-sensitive hashing to ensure that samples in each bucket si has a similar SOC and current load.

The key point in training the neural network ANN(si) lies: the number of input layer nodes : the number of hidden layer nodes : the number of output layer nodes = 1 : 0.5 : 1, and both the training set and labels are derived from TrainSet(si). An anomaly score strategy based on neural network reconstruction errors is designed.

In the present scenario embodiment, the following strategy is adopted for the early-warning stage of the early-warning model of the neural network:

(3) in the subset of a region corresponding to the current SOC and current load, the model and the threshold are found for warning determination:

constructing the current battery pack state vector and calculating UBC to obtain a new state vector Newr; finding the corresponding region number so on the basis of the current SOC and current load; importing the early-warning model ANN(so) and early-warning threshold θ(so) of the SOC + current load I subregion, and using equation 3 to determine whether to give an internal short circuit warning; and initiating result observation.

Before the end of an observation window of N hours, if no actual faults are observed, the battery pack state vector information represented by Newr is inserted into the normal sample set for the next round of training. The warning threshold is continuously updated on the basis of the feedback.

Steps of the present scenario embodiment are introduced below:

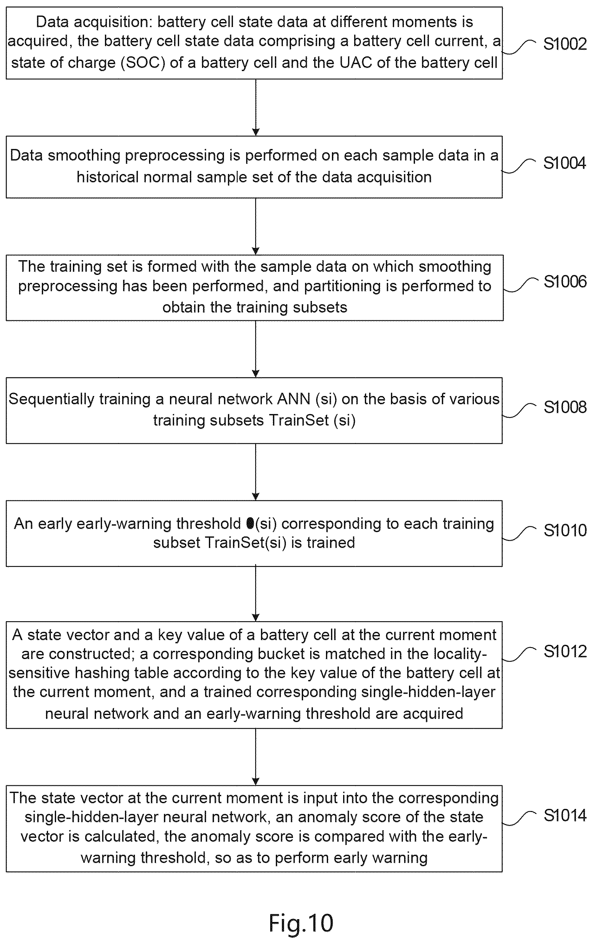

in the present scenario embodiment, the short circuit early-warning for energy storage batteries is divided into two stages for introduction: the training stage and the early-warning stage. Fig. 10 is a flowchart of a short circuit early-warning method for energy storage battery according to a scenario embodiment of the present disclosure. As shown in Fig. 10, the flow includes the following steps: training stage:

step S1002, data acquisition: battery cell state data at different moments is acquired, the battery cell state data including a battery cell current, a state of charge (SOC) of a battery cell and the UAC of the battery cell.

The most recent K sampling datasets of normal charge and discharge conditions from the energy storage battery pack (assuming N battery cells) are recorded, and a sampling interval is set as T seconds. Each row of original sample data row (t) includes a real-time current value I(t, i), a real-time SOC(t, i) and a UAC(t, i) of each battery cell i in the energy storage battery pack at the moment t, wherein UAC(t, i) = U(t, i)-U(t-1, i)/T, wherein U(t, i) is a real-time voltage value of the ith battery cell at the moment. The sampled data of the battery cells are shown in Table 1:

Table 1 Battery cell sampling data table

| Time stamp | Current of battery cell 1 | SOC of Battery cell 1 | U-Absolute Change of battery cell 1 | ... | Current of battery cell N | SOC of battery cell N | U-Absolute Change of battery cell N |
|---|---|---|---|---|---|---|---|
| 1 | I(1, 1) | SOC(1, 1) | UAC (1, 1) | .. | I(1, N) | SOC(1, N) | UAC (1, N) |
| ... | ... | ... | ... | .. | ... | ... | ... |
| k | I(k, 1) | SOC(k, 1) | UAC(k, 1) | .. | I(k, N) | SOC(k, N) | UAC(k, N) |
| ... | ... | ... | ... | .. | ... | ... | ... |
| K | I(K,1) | SOC(K,1) | UAC (K,1) | .. | I(K, N) | SOC(K, N) | UAC (K, N) |
|  |  |  |  |  |  |  |  |

The U-Absolute Changes in Table 1 are extracted, and a table of the U-Absolute Changes of the battery cell at a certain moment t can be obtained, as shown in Table 2:

Table 2 U-Absolute Change table

| UAC(t, 1) | UAC(t, 2) | ... | UAC(t, i) | ... | UAC(t, j) | ... | UAC(t, N) |
|---|---|---|---|---|---|---|---|
| 0.32 | 0.31 |  | 0.37 |  | 0.1 |  | 0.33 |

Step S1004: data smoothing preprocessing is performed on each sample data in a historical normal sample set of the data acquisition;

including:

1) multiple K-Medians clustering operations are performed on the UAC(t,i) within each row of the original sample data, row(t) (the number of clusters ranging from 1 to ceiling(sqrt(N)). a clustering result with the best clustering effect is selected by means of a calinski_harabasz index; the optimal number of clusters obtained from the partitioning is set to be Q(t), and the representative values of each cluster for the UAC(t,i) in sample row(t) is set to be UCenter(t,d), where d $\in$ [1, Q(t)]; and

2) for each sample data row(t), N columns of derived features are constructed according to equation (1), representing the UBC(t, i) of the battery cell i at the moment t:

$$UBC(t,i) = UAC(t,i) * \sum_{d=1}^{Q(t)} \frac{1}{\max(|UCenter(t,d)|, 0.001)} / Q(t) \qquad (1);$$

wherein *t* represents a moment, *i* represents an ith battery cell, *UBC(t,i)* represents the UAC of the ith battery cell at the moment *t*, *UAC(t,i)* represents the UBC of the ith battery cell at the moment *t*, *UCenter(t,d)* represents the UAC of a dth clustering center at the moment t, *Q(t)* represents an optimal number of clusters at the moment t, and $d \in [1, Q(t)]$, both i and d being integers.

After calculating the UBC using equation (1), the UAC in the original data is replaced with UBC. For a specific row, i.e., a specific moment, the UAC is replaced to obtain the U-Baseline Change table, as shown in table 3:

Table 3 U-Baseline Change table

| UBC(t, 1) | UBC(t, 2) | ... | UBC(t, i) | ... | UBC(t, j) | ... | UBC(t, N) |
|---|---|---|---|---|---|---|---|
| 1.41 | 1.37 | | 1.63 | | 0.44 | | 1.46 |

StepS1006: the training set is formed with the sample data on which smoothing preprocessing has been performed, and partitioning is performed to obtain the training subsets;
each row of the original sample data row(t) is reorganized; the UAC(t,i) of each battery cell i at the moment t is replaced with the UBC(t,i), to form the training sample data, train_row(t), to be trained; all train_row(t) form the training set TrainSet, structured as a matrix with K rows and 3*N columns, and the training sample data matrix is as shown in table 4:

Table 4 Training sample data matrix

| Time stamp | current of battery cell 1 | SOC of battery cell 1 | Voltage relative change rate of battery cell 1 | .. | Current of battery cell N | SOC of battery cell N | Voltage relative change rate of battery cell N |
|---|---|---|---|---|---|---|---|
| 1 | I(1, 1) | SOC( 1, 1) | UBC(1, 1) | ... | I(1, N) | SOC(1, N) | UBC(1, N) |
| .. | ... | .. | ... | . | ... | ... | ... |
| k | I(k, 1) | SOC( k, 1) | UBC(k, 1) | ... | I(k, N) | SOC(k, N) | UBC(k, N) |
| .. | ... | ... | ... | . | ... | ... | ... |
| K | I(K, 1) | SOC( K, 1) | UBC(K, 1) | ... | I(K, N) | SOC(K, N) | UBC(K, N) |

Then, partitioning a training subset according to the state of charge and the current distribution of the battery cell includes:

1) a locality-sensitive hash table HASH_SOC_I in which the number of buckets is HASH_TAB_SIZE is constructed;

2) the average SOC (avgsoc(t)) and the average current (avgi(t)) for the N battery cells in each row train_row(t) of the training set TrainSet are calculated; and a key value is constructed, key(t)=str.format(avgsoc(t)+'_'+avgi(t));

3) the rows of samples train_row(t) in TrainSet are inserted into the locality-sensitive hashing table HASH_SOC_I according to key(t);

4) a data subset in each bucket si of the locality-sensitive hashing table HASH_SOC_I is taked as a training subset TrainSet(si), and the training set is partitioned into independently disjoint subsets of HASH_TAB_SIZE parts corresponding to the matching of the locality-sensitive hashing table.

The locality-sensitive hashing table HASH_SOC_I is as follows:

Table 5 locality-sensitive hashing value

| Region number | Data subset TrainSet(si) |
|---|---|
| 1 | {thin_row(1),...} |

(continued)

| Region number | Data subset TrainSet(si) |
|---|---|
| ... | ... |
| si | {thin_row(2175),...} |
| ... | ... |
| HASH_TAB_SIZE | {thin_row(3999),...} |

Step S1008: sequentially training a neural network ANN (si) on the basis of various training subsets TrainSet (si); includes:

1) a single-hidden-layer neural network ANN(si) is constructed, wherein the number of input-layer nodes is 3*N, the number of output-layer nodes is 3*N, and the number of hidden-layer nodes is floor(1.5*N); the hidden-layer activation function is a hyperbolic tangent function (tanh); the loss function of the neural network is set as a mean squared error (MSE) loss function;

2) a training independent variable matrix and a training dependent variable matrix of a neural network ANN(si) are set to both be TrainSet(si);

3) the stochastic gradient descent (SGD) is used to perform network training until the mean square error loss function value of the neural network ANN(si) no longer descends in TrainSet(si).

The data structure of the single-hidden-layer neural network ANN(si) is shown in the following table:

Table 6 ANN data structure table

| Region number | Model subsetANN(si) |
|---|---|
| 1 | ANN(1) |
| ... | ... |
| si | ANN(si) |
| ... | ... |
| HASH_TAB_SIZE | ANN(HASH_TAB_SIZE) |

Step S1010: an early early-warning threshold $\theta(si)$ corresponding to each training subset TrainSet(si) is trained.
On the basis of TrainSet(si) and ANN(si), an abnormality early-warning threshold $\theta(si)$ corresponding to each si region is calculated; for each training subset TrainSet(si), input vectors of the training subset are input into the single-hidden-layer neural network one by one, to obtain a plurality of corresponding output vectors, wherein the input vectors are composed of a battery cell current, an SOC and a UBC; and then, a vector element difference between an output vector at each moment and an input vector in the training subset is calculated, and the maximum value of the vector element difference of the current training subset is used as an early-warning threshold of the current training subset.
Early-warning stage:

step S1012: a state vector and a key value of a battery cell at the current moment are constructed; a corresponding bucket is matched in the locality-sensitive hashing table according to the key value of the battery cell at the current moment, and a trained corresponding single-hidden-layer neural network and an early-warning threshold are acquired;

an internal short circuit prediction is performed, and the current data is preprocessed:

1) using the same processing logic as Step S1004, equation (1) is used to derive the variable UBC and obtain the state vector of each battery cell i in the battery pack at the current moment z: $newr(z)=<I(z, 1), Soc(z, 1), UBC(z, 1), ,I(z, i), Soc(z, i), UBC(z, i),...,I(z, N), Soc(z, N), UBC(z, N)>$

2) the mean value of the SOCs avgsoc(z) and the mean value of the currents avgi(z) of the battery cells of newr are calculated; and key(z)=str.format(avgsoc(z)+'_'+avg(z)) is constructed;

3) a corresponding bucket number, so, in the locality-sensitive hashing table HASH_SOC_I is acquired and obtained according to key(z); and

(4) a trained neural network ANN(so) and a warning threshold θ(so) of a corresponding region are acquired.

Step S1014: the state vector at the current moment is input into the corresponding single-hidden-layer neural network, an anomaly score of the state vector is calculated, the anomaly score is compared with the early-warning threshold, so as to perform early warning.

The trained ANN(so) and the warning threshold θ(so) are used to calculate the anomaly score abscore(newr) for newr, and determine whether the current battery pack has a risk of internal short circuit.

If the anomaly score abscore(newr) of the state vector is greater than or equal to the warning threshold θ(so), short circuit early-warning is performed. If the anomaly score abscore(newr) of the state vector is less than the warning threshold θ(so), short circuit early-warning is not performed.

In a practical implementation process, if it is determined that there is a risk, a warning is immediately given; if no actual fault is observed within E hours after this determination is completed, the current sample is recorded as a normal sample, and is used for the next round of training of the early-warning model. Here, the warning feedback is utilized to update the model and continuously promote the adaptability of the model.

Scenario Embodiment 2

In the present scenario embodiment, internal short circuit early-warning, early-warning success processing, is performed on a lithium ion battery.

Step S1101: after the lithium ion battery pack is deployed, data acquisition is started every 10 seconds; and state information about one month of recent normal working of the lithium ion battery pack (the SOC, load current I and UAC of each battery cell at each time point) is stored.

Step S1102: smooth preprocessing is performed on the sampling information about the normal working state of the lithium ion battery; equation 1 is used to calculate the UBC for each battery cell at that moment, so as to suppress the inherent differences between battery cells in the lithium battery pack and random sensor errors.

Step S1103: the UAC index of each battery cell in the original sample is replaced with a corresponding UBC index to obtain a training set TrainSet.

Step S1104: a key value, key, is constructed from the mean value of SOC and I of each sample in the TrainSet; and the key value is inserted into the locality-sensitive hashing table with 100 buckets. The samples in each bucket corresponding to the number si in the locality-sensitive hash table form a training subset TrainSet(si).

Step S1105: each training subset TrainSet(si) in the 100 buckets trains a single-hidden-layer neural network ANN(si). It is characterized in that: the number of input layer nodes of the neural network: the number of hidden layer nodes: the number of output layer nodes = 1:0.5:1; and a training independent variable matrix and a training dependent variable matrix of a neural network are both TrainSet(si).

Step S1106: the training subsets TrainSet(si) in the 100 buckets are input into the corresponding neural networks ANN(si); and according to equation 2, the maximum reconstruction error of normal samples in the <SOC, I> region where each training subset is located is calculated as the region warning threshold θ(si).

Step S1107: after model training is completed, the current state (the SOC, load current I and UAC of each battery cell at the current time point t0) of the corresponding lithium-ion battery pack is read; and equation 1 is used to calculate the UBC value for each battery cell and construct the state vector Newr; key is constructed by means of the mean value of the SOC and the I, so as to find a region number so corresponding to the SOC and the load I of the lithium ion battery pack at this moment.

Step S1108: the state vector Newr is input into the early-warning model ANN(so); and equation 3 is used to determine whether there is an inner short circuit risk in the lithium ion battery at the current moment t0. For example:

Table 7 U-Baseline Change table of lithium-ion battery battery cell

| UBC(t0, 1) | UBC(t0, 2) | ... | UBC(t0, i) | ... | UBC(t0, j) | ... | UBC(t, N) |
|---|---|---|---|---|---|---|---|
| 1.61 | 0.57 | | 1.63 | | 1.64 | | 1.56 |

In this case, the UBC fluctuation of battery cell 2 exceeds the normal range, the system considers that the early-warning score is greater than the region threshold θ(so), and the warning is started.

Step S1109: it continues waiting for 2 hours, during which a real fault is indeed observed (e.g., based on a temperature sensor warning/based on the handling result of the on-site personnel), it indicates that the state of the lithium-ion battery pack represented by Newr at the moment t0 is abnormal, and the previous strategy selection is correct. The previous samples at other moments may be placed into a normal sample database, and the model is retrained for the next morning; and a warning threshold is extracted. In this case, the warning threshold does not increase.

Scenario Embodiment 3

In the present scenario embodiment, the inner short circuit early-warning, error reporting processing, is performed on the sodium ion battery.

Step S1201: after the sodium-ion battery pack is deployed, data acquisition is started every 30 seconds; and state information about two months of recent normal working of the lithium ion battery pack (the SOC, load current I and UAC of each battery cell at each time point) is stored.

Step S1202: smooth preprocessing is performed on the sampling information about the normal working state of the sodium-ion battery; equation 1 is used to calculate the UBC for each battery cell at that moment, so as to suppress the inherent differences between battery cells in the sodium-ion battery pack and random sensor errors.

Step S1203: the UAC index of each battery cell in the original sample is replaced with a corresponding UBC index to obtain a training set TrainSet.

Step S1204: a key value, key, is constructed from the mean value of SOC and I of each sample in the TrainSet; and the key value is inserted into the locality-sensitive hashing table with 200 buckets. The samples in each bucket corresponding to the number si in the locality-sensitive hash table form a training subset TrainSet(si).

Step S1205: each training subset TrainSet(si) in the 200 buckets trains a single-hidden-layer neural network ANN(si). It is characterized in that: the number of input layer nodes of the neural network: the number of hidden layer nodes: the number of output layer nodes = 1:0.5:1; and a training independent variable matrix and a training dependent variable matrix of a neural network are both TrainSet(si).

Step S1206: the training subsets TrainSet(si) in the 200 buckets are input into the corresponding neural networks ANN(si); and according to equation 2, the maximum reconstruction error of normal samples in the <SOC, I> region where each training subset is located is calculated as the region warning threshold $\theta(si)$.

Step S1207: after model training is completed, the current state (the SOC, load current I and UAC of each battery cell at the current time point t0) of the corresponding sodium-ion battery pack is read; and equation 1 is used to calculate the UBC value for each battery cell and construct the state vector Newr; key is constructed by means of the mean value of the SOC and the I, so as to find a region number so corresponding to the SOC and the load I of the lithium ion battery pack at this moment.

Step S1208: the state vector Newr is input into the early-warning model ANN(so); and equation 3 is used to determine whether there is an inner short circuit risk in the lithium ion battery at the current moment t0.

Table 8 U-Baseline Change table of sodium ion battery battery cell

| UBC(t0, 1) | UBC(t0, 2) | ... | UBC(t0, i) | ... | UBC(t0, j) | ... | UBC(t, N) |
|---|---|---|---|---|---|---|---|
| 1.51 | 1.57 | | 1.63 | | 1.40 | | 1.56 |

In this case, the UBC fluctuation of battery cell j has exceeded the normal range. Based on prior training data, the system considers that an early-warning score is higher than the region threshold $\theta(so)$, and a warning is given.

Step S1209: it continues waiting for 2 hours, during which no real fault is observed (e.g., based on a temperature sensor warning/based on the handling result of on-site personnel), it indicates that the state of the sodium-ion battery pack represented by Newr at the moment t0 is normal, and the previous warning is a false alarm. The data is then placed to the normal sample database, awaiting retraining of the model and extraction of the warning threshold at midnight the next day. In this case, the warning threshold will be increased to avoid future false alarms.

In summary, the embodiments of the present disclosure provide a short circuit early-warning method and apparatus for an energy storage battery. It fully utilizes the prior knowledge that the basic parameters of individual battery cells within the same battery pack are similar. Based on artificial intelligence algorithms, it learns the reasonable fluctuation range of voltage change rates for each battery cell under various operating conditions and states of charge. Based on this, it is determined whether the voltage fluctuations of the battery cells in the battery pack indicate signs of an internal short circuit, thereby triggering an early warning. The energy storage battery pack periodically collects and reports its current and voltage state by means of sensors, uploading the data to the energy management system. The management system caches the data as a training set, and performs preprocessing, model training, and threshold setting. After the training of the model and the setting of the threshold are completed, the data reported by the energy storage battery pack will be subjected to internal short circuit early-warning determination, network management warning and continuous updating of the model by means of the model.

The technical solutions provided in the embodiments of the present disclosure can effectively avoid original differences of various battery cells in an energy storage battery pack and random errors of voltage sensors, and adaptively set a warning threshold under different SOC states and load conditions, thereby achieving the balance of stability, sensitivity and usability. The present disclosure can be applied to a cloud energy storage management system to early-warn short circuit phenomena in a lithium battery and prevent thermal runaway, thereby improving the safety of the energy storage lithium battery.

The content above only relates to preferred embodiments of the present disclosure, and is not intended to limit the present disclosure. The embodiments of the present disclosure may have various modifications and changes. Any modifications, equivalent replacements, improvements, etc. made within the principle of the embodiments of the present disclosure shall all fall within the scope of protection of the embodiments of the present disclosure.

**Claims**

1. A method for short circuit early-warning for an energy storage battery, comprising:

   performing clustering analysis on a U-Absolute Change ,UAC, of a battery cell, and calculating a U-Baseline Change ,UBC, of the battery cell according to the UAC of each clustering center;
   constructing a training set according to the UBC, and partitioning the training set into a plurality of training subsets using a locality-sensitive hashing table;
   respectively training an early-warning neural network model according to the plurality of training subsets, and respectively calculating an early-warning threshold of each training subset; and
   performing short circuit early-warning on a battery cell according to the early-warning neural network model and the early-warning threshold and in conjunction with battery cell state data at the current moment.

2. The method according to claim 1, wherein before performing clustering analysis on the UAC of the battery cell, and calculating the UBC of the battery cell according to the UAC of each clustering center, the method further comprises: acquiring battery cell state data at different moments, the battery cell state data comprising a battery cell current, a state of charge ,SOC, of a battery cell and the UAC of the battery cell.

3. The method according to claim 1, wherein performing clustering analysis on the UAC of the battery cell, and calculating the UBC of the battery cell according to the UAC of each clustering center comprise:

   performing K-Medians clustering on the UAC of the battery cell at each moment, selecting a clustering result with the best clustering effect, and acquiring the UAC of each clustering center; and
   calculating the UBC of the battery cell according to the UAC of each clustering center,

   $$UBC(t,i) = UAC(t,i) * \sum_{d=1}^{Q(t)} \frac{1}{\max(|UCenter(t,d)|, 0.001)} / Q(t)$$

   wherein t represents a moment, i represents an ith battery cell, $UBC(t,i)$ represents the UAC of the ith battery cell at the moment t, $UAC(t,i)$ represents the UBC of the ith battery cell at the moment t, $UCenter(t,d)$ represents the UAC of a dth clustering center at the moment t, $Q(t)$ represents an optimal number of clusters at the moment t, and $d \in [1,Q(t)]$, both i and d being integers.

4. The method according to claim 1, wherein constructing the training set according to the UBC, and partitioning the training set into a plurality of training subsets using the locality-sensitive hashing table comprise:

   using the UBC, the battery cell current and the SOC of the battery cell at different moments as training sample data to construct a training set;
   calculating an SOC mean value and a current mean value of N battery cells at each moment, and constructing a key value according to the SOC mean value and the current mean value, wherein N is a positive integer; and
   inserting the training sample data at different moments into the locality-sensitive hashing table according to the key value, and using the training sample data in each bucket in the locality-sensitive hashing table as a training subset.

5. The method according to claim 1, wherein respectively training the early-warning neural network model according to the plurality of training subsets, and respectively calculating the early-warning threshold of each training subset comprise:
constructing a corresponding single-hidden-layer neural network for each training subset, taking the training subset as an independent variable matrix and a dependent variable matrix of the single-hidden-layer neural network; and using a gradient descent algorithm for training, wherein the number of input-layer nodes of the single-hidden-layer neural network is 3*N, the number of output-layer nodes is 3*N, and the number of hidden-layer nodes is 1.5*N, wherein N is a positive integer.

6. The method according to claim 1, wherein respectively calculating the early-warning threshold of each training subset comprises:

for each training subset, inputting input vectors of the training subset into the single-hidden-layer neural network one by one, to obtain a plurality of corresponding output vectors, wherein the input vectors are composed of a battery cell current, an state of charge ,SOC, and a UBC;
calculating a vector element difference between an output vector at each moment and an input vector in the training subset, and using the maximum value of the vector element difference of the current training subset as an early-warning threshold of the current training subset.

7. The method according to claim 1, wherein performing short circuit early-warning on a battery cell according to the early-warning neural network model and the early-warning threshold and in conjunction with battery cell state data at the current moment comprises:

constructing a state vector and a key value of a battery cell at the current moment;
matching a corresponding bucket in the locality-sensitive hashing table according to the key value of the battery cell at the current moment, and acquiring a trained corresponding single-hidden-layer neural network and an early-warning threshold;
inputting the state vector at the current moment into the corresponding single-hidden-layer neural network, calculating an anomaly score of the state vector, comparing the anomaly score with the early-warning threshold, and in cases where the anomaly score is greater than or equal to the early-warning threshold, performing short circuit early-warning; and in cases where the anomaly score is less than the early-warning threshold, not performing short circuit early-warning.

8. The method according to claim 7, wherein constructing the state vector and the key value of the battery cell at the current moment comprises:

calculating the UBC of the battery cell at the current moment, and constructing the state vector of the battery cell according to the battery cell current SOC and UBC of the battery cell; and
calculating an SOC mean value and a current mean value of the battery cell at the current moment, and constructing the key value of the battery cell at the current moment according to the SOC mean value and the battery cell current mean value at the current moment.

9. The method according to claim 7, wherein inputting the state vector at the current moment into the corresponding single-hidden-layer neural network, and calculating the anomaly score of the state vector comprise:
inputting the state vector at the current moment into the corresponding single-hidden-layer neural network to obtain an output vector; calculating a maximum value of a vector element difference between the state vector and the output vector; and taking the maximum value of the vector element difference as an anomaly score of the state vector.

10. An apparatus for short circuit early-warning for an energy storage battery, comprising:

a clustering analysis module, configured to perform clustering analysis on a U-Absolute Change ,UAC, of a battery cell, and calculating a U-Baseline Change ,UBC, of the battery cell according to the UAC of each clustering center;
a set construction module, configured to construct a training set according to the UBC, and partition the training set into a plurality of training subsets using a locality-sensitive hashing table;
a network training module, configured to respectively train an early-warning neural network model according to the plurality of training subsets, and respectively calculate an early-warning threshold of each training subset; and
a state early-warning module, configured to perform short circuit early-warning on a battery cell according to the early-warning neural network model and the early-warning threshold and in conjunction with battery cell state data at the current moment.

11. The apparatus according to claim 10, further comprising:
a data acquisition module, configured to acquire battery cell state data at different moments, the battery cell state data comprising a battery cell current, a state of charge ,SOC, of a battery cell and the UAC of the battery cell.

12. The apparatus according to claim 10, wherein the set construction module comprises:

a training set construction unit, configured to use the UBC, the battery cell current and the SOC of the battery cell at different moments as training sample data to construct a training set;
a key value construction unit, configured to calculate an SOC mean value and a current mean value of N battery cells at each moment, and constructing a key value according to the SOC mean value and the current mean value, wherein N is a positive integer; and
a subset partitioning unit, configured to insert the training sample data at different moments into the locality-sensitive hashing table according to the key value, and use the training sample data in each bucket in the locality-sensitive hashing table as a training subset.

13. The apparatus according to claim 10, wherein the state early-warning module comprises:

a vector and key value construction unit, configured to construct a state vector and a key value of a battery cell at the current moment;
a location matching unit, configured to match a corresponding bucket in the locality-sensitive hashing table according to the key value of the battery cell at the current moment, and acquire a trained corresponding single-hidden-layer neural network and an early-warning threshold;
an early-warning detection unit, configured to input the state vector at the current moment into the corresponding single-hidden-layer neural network, calculate an anomaly score of the state vector, compare the anomaly score with the early-warning threshold, and in cases where the anomaly score is greater than or equal to the early-warning threshold, perform short circuit early-warning; and in cases where the anomaly score is less than the early-warning threshold, not perform short circuit early-warning.

14. A computer readable storage medium, wherein a computer program is stored in the computer readable storage medium , and the computer program is configured to cause, when executed by a processor, the processor to perform steps of the method as claimed in any one of claims 1 to 9.

15. An electronic device, comprising a memory, a processor, and a computer program that is stored in the memory and executable on the processor, wherein the processor is configured to execute the computer program to perform steps of the method as claimed in any one of claims 1 to 9.

Transmission device 106

Input/output device 108

Processor 102

Memory 104

Fig.1

Clustering analysis is performed on a U-Absolute Change (UAC) of a battery cell, and a U-Baseline Change (UBC) of the battery cell is calculated according to the UAC of each clustering center — S202

A training set is constructed according to the UBC, and the training set is partitioned into a plurality of training subsets using a locality-sensitive hashing table — S204

An early-warning neural network model is respectively trained according to the plurality of training subsets, and an early-warning threshold of each training subset is respectively calculated — S206

Short circuit early-warning is performed on a battery cell according to the early-warning neural network model and the early-warning threshold and in conjunction with battery cell state data at the current moment — S208

Fig.2

battery cell state data at different moments is acquired, the battery cell state data including a battery cell current, a state of charge (SOC) of a battery cell and the UAC of the battery cell — S302

Clustering analysis is performed on a U-Absolute Change (UAC) of a battery cell, and a U-Baseline Change (UBC) of the battery cell is calculated according to the UAC of each clustering center — S304

A training set is constructed according to the UBC, and the training set is partitioned into a plurality of training subsets using a locality-sensitive hashing table — S306

An early-warning neural network model is respectively trained according to the plurality of training subsets, and an early-warning threshold of each training subset is respectively calculated — S308

Short circuit early-warning is performed on a battery cell according to the early-warning neural network model and the early-warning threshold and in conjunction with battery cell state data at the current moment — S310

Fig.3

The UBC, the battery cell current and the SOC of the battery cell at different moments are used as training sample data to construct a training set — S402

An SOC mean value and a current mean value of N battery cells at each moment are calculated, and a key value is constructed according to the SOC mean value and the current mean value, wherein N is a positive integer — S404

An SOC mean value and a current mean value of N battery cells at each moment are calculated, and a key value is constructed according to the SOC mean value and the current mean value, wherein N is a positive integer — S406

Fig.4

A state vector and a key value of a battery cell at the current moment are constructed ⟋ S502

A corresponding bucket is matched in the locality-sensitive hashing table according to the key value of the battery cell at the current moment, and a trained corresponding single-hidden-layer neural network and an early-warning threshold are acquired ⟋ S504

The state vector at the current moment is input into the corresponding single-hidden-layer neural network, an anomaly score of the state vector is calculated, the anomaly score is compared with the early-warning threshold, and in cases where the anomaly score is greater than or equal to the early-warning threshold, short circuit early-warning is performed; and in cases where the anomaly score is less than the early-warning threshold, short circuit early-warning is not performed ⟋ S506

Fig.5

Early-warning apparatus 60

Clustering analysis module 610

Set construction module 620

Network training module 630

State early-warning module 640

Fig.6

Early-warning apparatus 70

Data acquisition module
710

Clustering analysis module
610

Set construction module
620

Network training module
630

State early-warning
module 640

Fig.7

Set construction module 620

Training set construction
unit 810

Key value construction unit
820

Subset partitioning unit 830

Fig.8

State early-warning
module 640

Vector and key value
construction unit 910

Location matching unit 920

Early-warning detection
unit 930

Fig.9

Data acquisition: battery cell state data at different moments is acquired, the battery cell state data comprising a battery cell current, a state of charge (SOC) of a battery cell and the UAC of the battery cell — S1002

Data smoothing preprocessing is performed on each sample data in a historical normal sample set of the data acquisition — S1004

The training set is formed with the sample data on which smoothing preprocessing has been performed, and partitioning is performed to obtain the training subsets — S1006

Sequentially training a neural network ANN (si) on the basis of various training subsets TrainSet (si) — S1008

An early early-warning threshold ⚫(si) corresponding to each training subset TrainSet(si) is trained — S1010

A state vector and a key value of a battery cell at the current moment are constructed; a corresponding bucket is matched in the locality-sensitive hashing table according to the key value of the battery cell at the current moment, and a trained corresponding single-hidden-layer neural network and an early-warning threshold are acquired — S1012

The state vector at the current moment is input into the corresponding single-hidden-layer neural network, an anomaly score of the state vector is calculated, the anomaly score is compared with the early-warning threshold, so as to perform early warning — S1014

Fig.10

## INTERNATIONAL SEARCH REPORT

| International application No. |
| --- |
| **PCT/CN2023/131622** |

| A. | CLASSIFICATION OF SUBJECT MATTER |
| --- | --- |

G01R31/52(2020.01)i;  G01R31/385(2019.01)i

According to International Patent Classification (IPC) or to both national classification and IPC

| B. | FIELDS SEARCHED |
| --- | --- |

Minimum documentation searched (classification system followed by classification symbols)

IPC：G01R31/-

Documentation searched other than minimum documentation to the extent that such documents are included in the fields searched

Electronic data base consulted during the international search (name of data base and, where practicable, search terms used)

CNKI, CNTXT, USTXT, WOTXT, ENTXTC: 中兴, 华为, 储能, 电池, 短路, 预警, 电芯, 电压, 相对变化率, 哈希, 聚类, 集, 预警, 神经网络, 提示, 提醒, 训练, UAC, UBC, hash, energy, storage, short, circuit, set, warn, neural, network, train

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | CN 111142027 A (STATE GRID NARI NANJING CONTROL SYSTEM CO., LTD. et al.) 12 May 2020 (2020-05-12) description, paragraphs [0032]-[0109], and figures 1 and 4 | 1-15 |
| A | CN 109143085 A (CHINA ELECTRIC POWER RESEARCH INSTITUTE CO., LTD. et al.) 04 January 2019 (2019-01-04) entire document | 1-15 |
| A | CN 113935423 A (GUANGZHOU INSTITUTE OF ENERGY TESTING) 14 January 2022 (2022-01-14) entire document | 1-15 |
| A | CN 114417948 A (CHONGQING CHANGAN AUTOMOBILE CO., LTD. et al.) 29 April 2022 (2022-04-29) entire document | 1-15 |
| A | CN 114578251 A (STATE GRID ANHUI ELECTRIC POWER CO., LTD., ELECTRIC POWER SCIENCE RESEARCH INSTITUTE et al.) 03 June 2022 (2022-06-03) entire document | 1-15 |

☑ Further documents are listed in the continuation of Box C.     ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **16 January 2024** | **23 January 2024** |

| Name and mailing address of the ISA/CN | Authorized officer |
| --- | --- |
| **China National Intellectual Property Administration (ISA/ CN) China No. 6, Xitucheng Road, Jimenqiao, Haidian District, Beijing 100088** | |
| | Telephone No. |

Form PCT/ISA/210 (second sheet) (July 2022)

**EP 4 614 174 A1**

**INTERNATIONAL SEARCH REPORT**

| International application No. |
| --- |
| **PCT/CN2023/131622** |

**C.    DOCUMENTS CONSIDERED TO BE RELEVANT**

| Category* | Citation of document, with indication, where appropriate, of the relevant passages | Relevant to claim No. |
| --- | --- | --- |
| A | US 2022261889 A1 (CAPITAL ONE SERVICES, LLC) 18 August 2022 (2022-08-18)<br>entire document | 1-15 |

**INTERNATIONAL SEARCH REPORT**
Information on patent family members

International application No.

**PCT/CN2023/131622**

| Patent document cited in search report | | | Publication date (day/month/year) | Patent family member(s) | | | Publication date (day/month/year) |
|---|---|---|---|---|---|---|---|
| CN | 111142027 | A | 12 May 2020 | None | | | |
| CN | 109143085 | A | 04 January 2019 | None | | | |
| CN | 113935423 | A | 14 January 2022 | None | | | |
| CN | 114417948 | A | 29 April 2022 | None | | | |
| CN | 114578251 | A | 03 June 2022 | None | | | |
| US | 2022261889 | A1 | 18 August 2022 | WO | 2022177626 | A1 | 25 August 2022 |
| | | | | US | 11798074 | B2 | 24 October 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211611439